# EUROPEAN PATENT APPLICATION

(11) **EP 4 794 053 A1**
(43) Date of publication of application: **19.08.2026**
(21) Application number: 25221466.3
(22) Date of filing: 08.12.2025
(51) Int. Cl.: H01M 10/42, H01M 10/48, H01M 10/613, H01M 10/633, H01M 10/6567

(54) **BATTERY MANAGEMENT APPARATUS AND METHOD FOR MONITORING ABNORMALITIES IN BATTERY DIELECTRIC COOLANT, AND IMMERSION-TYPE ENERGY STORAGE DEVICE UTILIZING THE SAME**

(30) Priority: 18.02.2025 KR 20250020613
(71) Applicant: Hanwha Engine Co., Ltd., Gyeongsangnam-do (Sinchon-dong) (KR)
(72) Inventor: Lee, Seung Ki, Changwon-si, Gyeongsangnam-do 51542 (KR); Kim, Bum Jun, Changwon-si, Gyeongsangnam-do 51542 (KR)
(74) Representative: Gulde & Partner

(57) **Abstract**

An immersion-type energy storage device includes, a housing having an accommodation space therein, one or more battery cells accommodated in the accommodation space of the housing, insulating oil that fills the accommodation space to immerse the battery cells and cool the battery cells, a temperature sensor array including a plurality of temperature sensors installed at different locations that are vertically spaced apart in the accommodation space to detect temperature, and a battery management apparatus configured to determine whether a defect has occurred in the insulating oil based on whether a pattern of a temperature signal detected by the plurality of temperature sensors has changed over time.

## Description

### BACKGROUND

### 1. Field

The present disclosure relates to a technology for monitoring a defect in insulating oil used to cool a battery by immersion, and more particularly, to a battery management apparatus and method capable of monitoring a defect in the cooling oil using temperature sensors installed in advance in a battery module, without requiring separate additional sensors.

### 2. Description of the Related Art

Recently, environmental issues such as carbon emission reduction and carbon neutrality have emerged as major concerns in the generation and use of energy from various sources. As a result, the use of storage batteries that can store energy and be secondarily charged has rapidly increased. These storage batteries are being increasingly used in various technical fields, such as electric propulsion systems for electric vehicles, industrial vehicles, agricultural machinery, ships, submarines, and aircraft, as well as industrial energy storage systems (ESSs).

With the advancement of storage battery technologies, safety and performance have become the most critical factors. To address these aspects, various thermal runaway/propagation prevention and cooling techniques have been developed, among which an immersion cooling technique has recently gained attention due to its high cooling efficiency and safety. The immersion cooling technique maintains the insulation and cooling performance of battery cells and enhances stability during thermal runaway by immersing the battery cells directly in an insulating oil with excellent insulating and cooling properties.

As such, one of the key factors in the immersion cooling technique is to maintain the insulating oil inside the battery enclosure in a state capable of delivering sufficient performance. If a defect occurs in the insulating oil for any reason, it may lead to degradation in cooling and insulation performance, which can cause issues such as battery cell performance degradation, overheating, short circuits, or fire.

Generally, defects in the insulating oil include leakage and degradation of the insulating oil itself. Leakage refers to a situation where the insulating oil escapes to the outside of the battery enclosure due to various causes, resulting in a decrease in the amount of insulating oil inside the battery enclosure. Degradation refers to a deterioration in the performance of the insulating oil itself even without leakage. This degradation may result from contamination of the insulating oil, changes in its composition or viscosity due to prolonged use, and other similar causes.

Leakage of the insulating oil can be detected using level sensors (or liquid level sensors) installed at various heights. That is, when a part of each level sensor that contacts the insulating oil produces a contact signal, leakage can be determined if the level of the insulating oil drops below a specific threshold based on the contact signal.

However, in this case, multiple level sensors are required depending on the monitoring location, and additional components such as power supplies, input/output (I/O) interfaces, and harnesses are also needed. This increases the complexity of the entire system and raises costs.

Meanwhile, degradation of the insulating oil can be detected using viscosity sensors or optical sensors to sense transparency. However, similar to the installation of level sensors, this also requires such sensors and their accompanying components, leading to similar issues.

Also, various insulating oil defects are directly observed by the operator's naked eye. However, visual observation not only causes inconvenience for the operator, but is also practically impossible because battery packs are often installed in vehicles, ships, submarines, aircraft, and other settings where frequent visual inspection is infeasible.

Notably, temperature sensors, such as thermistors, capable of measuring the temperature of each battery region or multiple battery regions are already installed inside the enclosure of an immersion-type battery. Therefore, there is a need for a solution that monitors defective states of battery insulating oil, such as leakage or degradation, by analyzing change patterns over time in temperature values (or temperature signals) measured by the already-installed temperature sensors.

### SUMMARY

One objective of the present disclosure is to provide a battery management apparatus and method capable of monitoring a defect in insulating oil based on the temporal variation in battery temperature measured at different locations, by installing a temperature sensor array at various positions inside an immersion-type battery enclosure.

The objectives of the present disclosure are not limited to those mentioned above, and other objectives not explicitly stated will be clearly understood by those skilled in the art based on the following description.

According to an aspect of the present disclosure, there is provided an immersion-type energy storage device comprising: a housing having an accommodation space therein; one or more battery cells accommodated in the accommodation space of the housing; insulating oil that fills the accommodation space to immerse the battery cells and cool the battery cells; a temperature sensor array including a plurality of temperature sensors installed at different locations that are vertically spaced apart in the accommodation space to detect temperature; and a battery management apparatus configured to determine whether a defect has occurred in the insulating oil based on whether a pattern of a temperature signal detected by the plurality of temperature sensors has changed over time.

The battery cells may be mounted in a module casing of a battery module and immersed in the insulating oil, and the plurality of temperature sensors are installed on the module casing.

The defect in the insulating oil may include leakage and degradation of the insulating oil.

The temperature signal may be defined as a representative value of multiple sampled values.

The battery management apparatus may determine that the defect in the insulating oil has occurred only when the pattern of the temperature signal has changed and has continued for more than a predetermined period of time.

The battery management apparatus may determine whether a defect has occurred in the insulating oil when the battery cells are in a charging state or a discharging state, based on a signal from a current sensor.

The battery management apparatus may determine whether a defect has occurred in the insulating oil when the immersion-type energy storage device is placed at an inclination angle less than a threshold angle, based on a signal from an inclination sensor.

The plurality of temperature sensors may form an individual temperature sensor column connected by a common signal line.

A plurality of temperature sensor columns may be formed as individual temperature sensor columns are installed at different locations in a horizontal direction of the module casing.

The battery management apparatus may determine that a defect has occurred in the insulating oil when a change in the pattern of the temperature signal is detected in at least one of the plurality of temperature sensor columns.

The battery management apparatus may determine that a defect has occurred in the insulating oil when a change in the pattern of the temperature signal is detected in all of the plurality of temperature sensor columns.

One or more temperature sensors may be positioned at a highest position in the plurality of temperature sensor columns are located in a circuit section of the module casing.

A single temperature sensor may be located in the circuit section, and is commonly connected to signal lines of the plurality of temperature sensor columns.

The battery management apparatus may determine that leakage of the insulating oil has occurred when a magnitude reversal pattern has occurred in which a temperature signal detected by a first temperature sensor located at a first position is lower than a temperature signal detected by a second temperature sensor located at a second position below the first position.

The battery management apparatus may determine that leakage of the insulating oil has occurred when a gradient reversal pattern has occurred in which a time gradient of a temperature signal detected by a first temperature sensor located at a first position is smaller than a time gradient of a temperature signal detected by a second temperature sensor located at a second position below the first position.

The battery management apparatus may determine that leakage of the insulating oil has occurred when a peak shift pattern has occurred in which a peak position of a temperature signal detected by a first temperature sensor located at a first position differs in time from a peak position of a temperature signal detected by a second temperature sensor located at a second position below the first position.

The battery management apparatus may determine that the peak shift pattern has occurred when a sign of a difference between a temperature signal detected by the first temperature sensor at a previous time and a temperature signal detected by the first temperature sensor at a current time differs from a sign of a difference between a temperature signal detected by the second temperature sensor at the previous time and a temperature signal detected by the second temperature sensor at the current time.

The battery management apparatus may determine that degradation of the insulating oil has occurred when a peak height of a temperature signal detected by at least one of the plurality of temperature sensors falls below a reference level by more than a threshold amount.

The battery management apparatus may determine that degradation of the insulating oil has occurred when a peak height of a temperature signal detected by a temperature sensor located at a highest position among the plurality of temperature sensors falls below the reference level by more than the threshold amount.

According to another aspect of the present disclosure, there is provided a battery management method performed in a device including a processor and a memory that stores program instructions executed by the processor, the method comprising: receiving, from a temperature sensor array including a plurality of temperature sensors installed at different vertical positions, a temperature signal detected by the plurality of temperature sensors; determining, based on a current signal provided by a current sensor, whether battery cells are in a charging state or a discharging state; and when the battery cells are in the charging state or the discharging state, determining whether a defect has occurred in insulating oil that immerses the battery cells based on whether a pattern of the temperature signal detected by the plurality of temperature sensors has changed over time.

According to the battery management apparatus and method of the present disclosure, various defects in the insulating oil that immerses the battery, for example leakage or degradation, can be monitored without requiring any additional sensors other than the existing temperature sensor array. As a result, the cost associated with the installation of separate sensors and accompanying components can be reduced, and space utilization can be improved.

It should be noted that the effects of the present disclosure are not limited to those described above, and other effects of the present disclosure will be apparent from the following description.

### BRIEF DESCRIPTION OF THE DRAWINGS

The above and other aspects and features of the present disclosure will become more apparent by describing exemplary embodiments in detail with reference to the attached drawings, in which:
FIG. 1 is a perspective view of an immersion-type energy storage device according to an embodiment of the present disclosure;
FIG. 2 is a plan view of the immersion-type energy storage device of FIG. 1 with its housing cover removed;
FIG. 3 is a side cross-sectional view of the immersion-type energy storage device of FIG. 1;
FIGS. 4A and 4B are a side cross-sectional view and a front cross-sectional view, respectively, of a battery module;
FIGS. 5A through 5C are front views of battery modules in which temperature sensor arrays according to various embodiments of the present disclosure are installed;
FIG. 6 is a schematic view illustrating the connection configuration of a temperature sensor array;
FIG. 7 is a side cross-sectional view of an immersion-type energy storage device according to another embodiment of the present disclosure;
FIG. 8 is a block diagram illustrating the configuration of a battery management apparatus according to an embodiment of the present disclosure;
FIG. 9 is a graph showing temporal temperature changes of normal insulating oil for a plurality of temperature sensors vertically spaced apart within an individual temperature sensor column;
FIG. 10 is a graph showing temporal temperature changes of insulating oil in which leakage has occurred, for a plurality of temperature sensors vertically spaced apart within an individual temperature sensor column;
FIG. 11 is a graph showing temporal temperature changes of degraded insulating oil for a plurality of temperature sensors vertically spaced apart within an individual temperature sensor column; and
FIG. 12 is a flowchart illustrating a battery management method according to an embodiment of the present disclosure.

### DETAILED DESCRIPTION

Advantages and features of the disclosure and methods to achieve them will become apparent from the descriptions of exemplary embodiments herein below with reference to the accompanying drawings. However, the inventive concept is not limited to exemplary embodiments disclosed herein but may be implemented in various ways. The exemplary embodiments are provided for making the disclosure of the inventive concept thorough and for fully conveying the scope of the inventive concept to those skilled in the art. It is to be noted that the scope of the disclosure is defined only by the claims. Like reference numerals denote like elements throughout the descriptions.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and/or the present application, and will not be interpreted in an idealized or overly formal sense unless expressly so defined herein.

Terms used herein are for illustrating the embodiments rather than limiting the present disclosure. As used herein, the singular forms are intended to include plural forms as well, unless the context clearly indicates otherwise. Throughout this specification, the word "comprise" and variations such as "comprises" or "comprising," will be understood to imply the inclusion of stated elements but not the exclusion of any other elements.

Hereinafter, exemplary embodiments of the present disclosure will be described in detail with reference to the accompanying drawings.

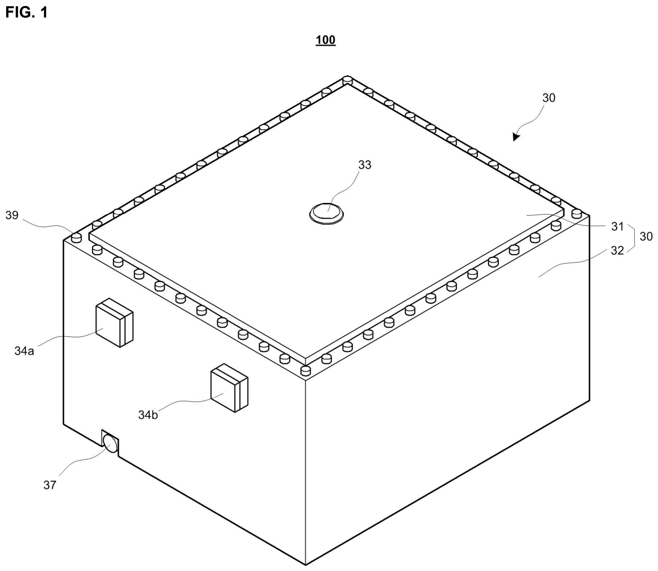

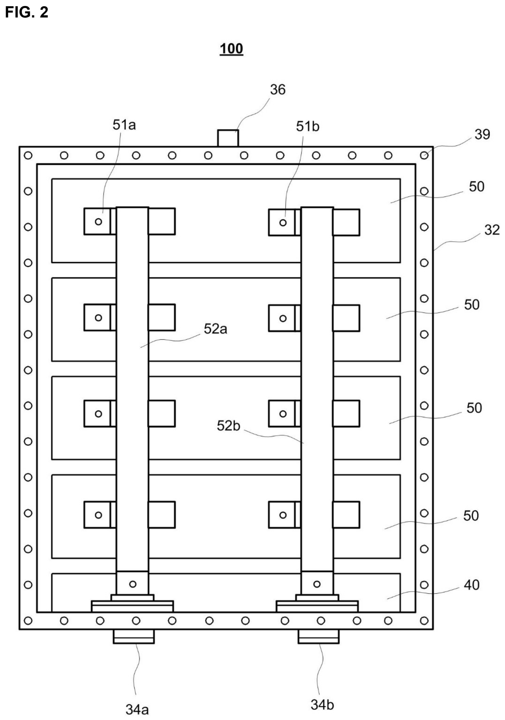

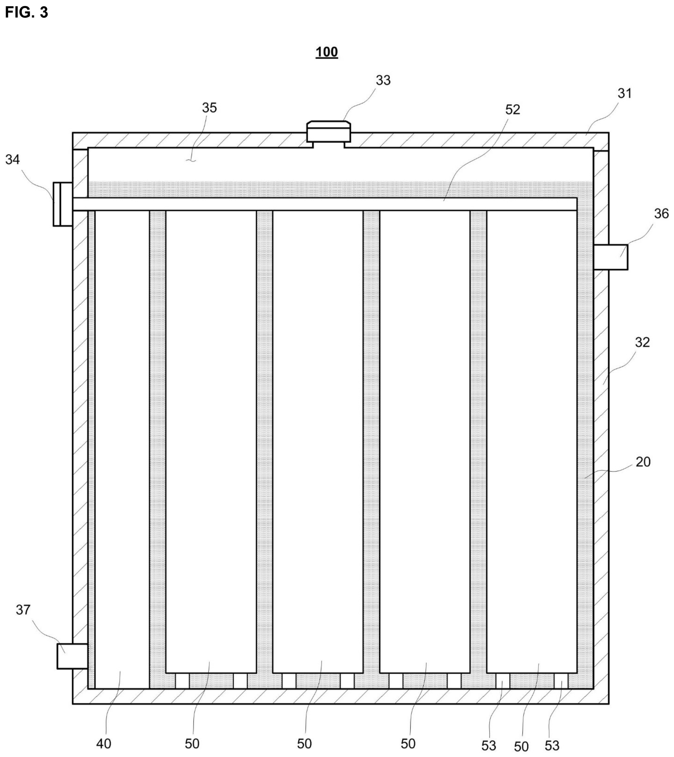

FIG. 1 is a perspective view of an immersion-type energy storage device 100 according to an embodiment of the present disclosure, FIG. 2 is a plan view of the immersion-type energy storage device 100 with its housing cover 31 removed, and FIG. 3 is a side cross-sectional view of the immersion-type energy storage device 100 of FIG. 1.

Referring to FIGS. 1 through 3, the immersion-type energy storage device 100 includes a housing 30, one or more battery modules 50, and insulating oil 20.

The housing 30 is an external case that defines an internal accommodation space 35 and seals the accommodation space 35 from the external environment. The battery modules 50 and additional components of the immersion-type energy storage device 100 are housed in the accommodation space 35. The additional components may include a high-voltage connection bus bar, a voltage sensor, a current sensor, a gas sensor, a tilt sensor, a battery management system (BMS), and the like. Specifically, the BMS may be placed in a BMS casing 40 positioned near the front of the housing 30 within the accommodation space 35, but the present disclosure is not limited thereto. The BMS is communicatively connected to the battery modules 50 to control the operation of the battery modules 50 or to receive information from the battery modules 50.

As illustrated in FIG. 2, bus bars 52a and 52b may be connected to terminals 51a and 51b that are positioned at the positive and negative electrodes, respectively, of each of the battery modules 50, and may thus be electrically connected to the outside through high-voltage connection terminals 34.

The housing 30 may be formed as an integral structure. Alternatively, the housing 30 may include a housing body 32 and the housing cover 31, which are joined together by fastening means 39 such as screws, pins, welding, clamps, and the like. Accordingly, the accommodation space 35 of the housing 30 is in a sealed state, isolated from the outside.

In this case, a gas vent 33 for discharging off-gas generated in the battery modules 50 may be installed in the housing cover 31. In FIG 1, the gas vent 33 is illustrated as being located on the upper surface of the housing 30, i.e., on the housing cover 31, but the location of said gas vent 33 is not limited thereto. For example, the gas vent 33 may be installed on any one of the front, rear and two sides of the housing body 32.

The gas vent 33 may be selectively opened only when the pressure of the off-gas generated in battery cells 10 exceeds a threshold value, in order to discharge the off-gas to the outside. Such off-gas is generated in large quantities when the battery cells 10 are in a thermal runaway state.

Additionally, optionally, the housing body 32 may be provided with an inlet 36 for injecting or replenishing insulating oil 20 into the accommodation space 35 and an outlet 37 for discharging insulating oil 20 from the accommodation space 35 to the outside, on sides of the housing body 32.

Each of the battery modules 50 is a unit structure that houses a plurality of battery cells 10, each capable of storing electrical energy, within a module casing 59. The form factors of the plurality of battery cells 10 included in each of the battery modules 50 may have various shapes such as prismatic, cylindrical, and pouch (or flat). However, for convenience, the form factors of the plurality of battery cells 10 will hereinafter be described as having, for example, a cylindrical shape.

The battery modules 50 may be immersed in the insulating oil 20 that fills a significant portion of the accommodation space 35. Although the amount of insulating oil 20 filling the accommodation space 35 may vary depending on the design purpose of the device, it is preferable for all of the plurality of battery modules 50 housed in the immersion-type energy storage device 100 to be fully immersed in the insulating oil 20. Even in this case, however, it is preferable to form an air layer in an upper portion of the accommodation space 35 rather than completely filling the accommodation space 35 with the insulating oil 20. Advantageously, this air layer serves as a buffer in the event of boiling or splashing of the insulating oil 20 due to thermal runaway, thereby suppressing damage to the housing 32, and also helps the insulating oil 20 flow and circulate smoothly within the accommodation space 35.

The insulating oil 20 may preferably have high specific heat, thermal conductivity, and boiling point, and be resistant to corrosion of the battery cells 10 or the housing 30, as well as to thermal decomposition, air oxidation, and electrolysis. Also, to prevent short circuits in conductors connected to the battery cells 10, the insulating oil 20 may preferably be an electrically insulating liquid. For example, the insulating oil 20 may include a hydrocarbon-based liquid, silicon compound, or fluorine-based inert liquid.

Even if a thermal runaway phenomenon occurs in the battery cells 10, the insulating oil 20 disperses heat through fluid flow/convection, thereby reducing the occurrence of secondary damage such as fire or explosion. To promote smooth flow of the insulating oil 20, spacers 53 are provided at the bottom of each of the battery modules 50. Accordingly, the insulating oil 20 can effectively absorb and dissipate heat generated from the battery modules 50 or the BMS casing 40, while flowing along the top, sides, and bottom of each of the battery modules 50. In this manner, even without the aid of separate circulation devices such as pumps or screws, the insulating oil 20 can flow naturally within the accommodation space 35 due to its upward movement by heating and downward movement by cooling.

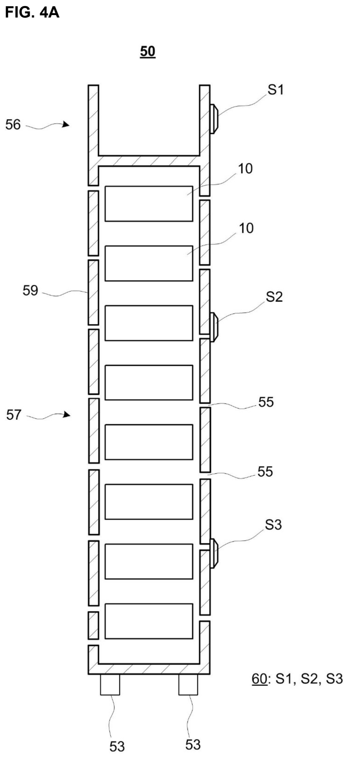

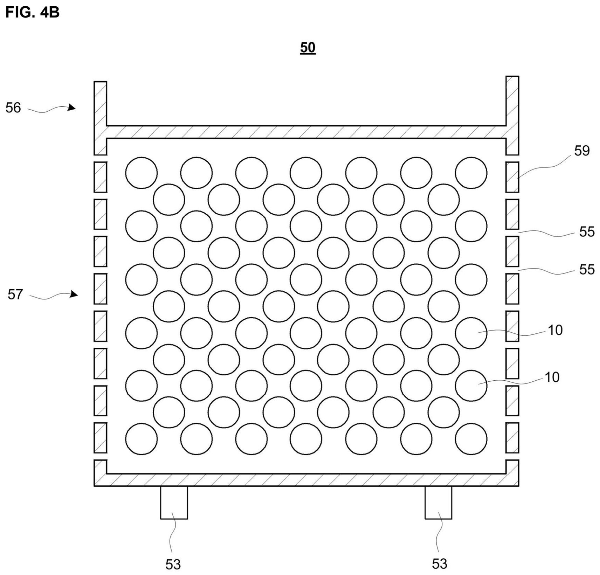

FIGS. 4A and 4B are a side cross-sectional view and a front cross-sectional view, respectively, of a battery module 50.

Referring to FIGS. 4A and 4B, the battery module 50 may include a plurality of battery cells 10 and a module casing 59 that houses the battery cells 10. A plurality of through-holes 55 are formed in the module casing 59, allowing the insulating oil 20 on the outside of the battery module 50 to flow into and out of the module casing 59 through the through-holes 55. Accordingly and advantageously, the battery cells 10 can directly contact the insulating oil 20, thereby improving heat exchange efficiency.

A temperature sensor array 60 is provided at the front of the module casing 59 and includes a plurality of temperature sensors S1, S2, and S3 that are spaced apart in the vertical direction of the accommodation space 35. The module casing 59 may include a battery section 57 that houses the battery cells 10, and a circuit section 56 that is located above the battery section 57 and houses circuit components.

In the battery section 57, the battery cells 10 may be densely arranged and housed, and in the circuit section 56, electrode terminals 51a and 51b for connection to a circuit board (not illustrated) and bus bars 52a and 52b may be arranged. The circuit board is configured to control the battery cells 10 or transmit information from the battery cells 10 while communicating with a BMS.

Accordingly, when the battery module 50 is immersed in the insulating oil 20, the battery cells 10, the temperature sensor array 60, the circuit board, the electrode terminals 51a and 51b, and the bus bars 52a and 52b may also be immersed in the insulating oil 20 and thus may perform heat exchange with the insulating oil 20.

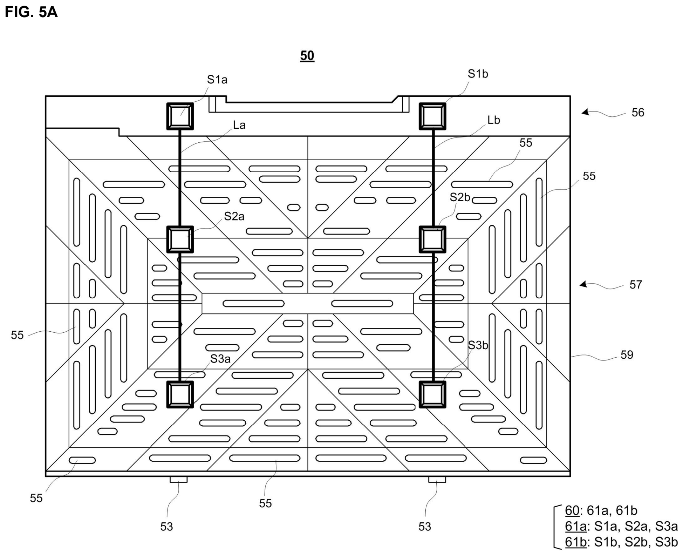

FIGS. 5A through 5C are front views of battery modules 50 in which temperature sensor arrays 60 according to various embodiments of the present disclosure are installed.

Referring to FIG. 5A, temperature sensors S1a, S2a, and S3a or S1b, S2b, and S3b are arranged at positions spaced apart in the vertical direction of the accommodation space 35. The temperature sensors S1a, S2a, and S3a or S1b, S2b, and S3b may be connected to one another by a signal line La or Lb. The temperature sensors S1a, S2a, and S3a or S1b, S2b, and S3b may be defined as a temperature sensor column 61a or 61b.

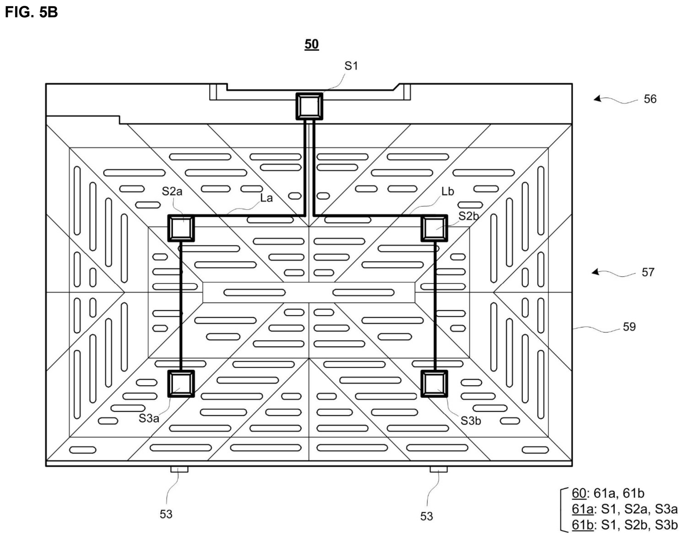

In the present disclosure, the term "positions spaced apart in the vertical direction" does not necessarily mean that the positions are aligned in a straight line along the vertical direction. Rather, as long as the temperature sensors S1a, S2a, and S3a or S1b, S2b, and S3b are arranged at positions that differ in height in the vertical direction, they are considered to be spaced apart vertically. For example, as illustrated in FIG. 5B, the temperature sensors S1, S2a, and S3a are not arranged in a straight vertical line, but may still be considered spaced apart from one another in the vertical direction, i.e., having different heights.

In FIG. 5A, two separate temperature sensor columns 61a and 61b are illustrated as being installed at different positions in the horizontal direction of a module casing 59. The entirety of the two temperature sensor columns 61a and 61b may be defined as a temperature sensor array 60.

In the temperature sensor columns 61a and 61b, the temperature sensors S1a and S1b, located at the highest positions, may be placed in a circuit section 56 of the module casing 59, but the present disclosure is not limited thereto. Alternatively, all the temperature sensors included in each of the temperature sensor columns 61a and 61b may be placed only within a battery section 57 of the module casing 59.

In FIG. 5A, the temperature sensor array 60 is illustrated as including a total of six temperature sensors S1a, S2a, S3a, S1b, S2b, and S3b, with three vertical sensor rows and two horizontal sensor columns. However, the numbers of vertical sensor rows and horizontal sensor columns are not limited to those illustrated and may vary.

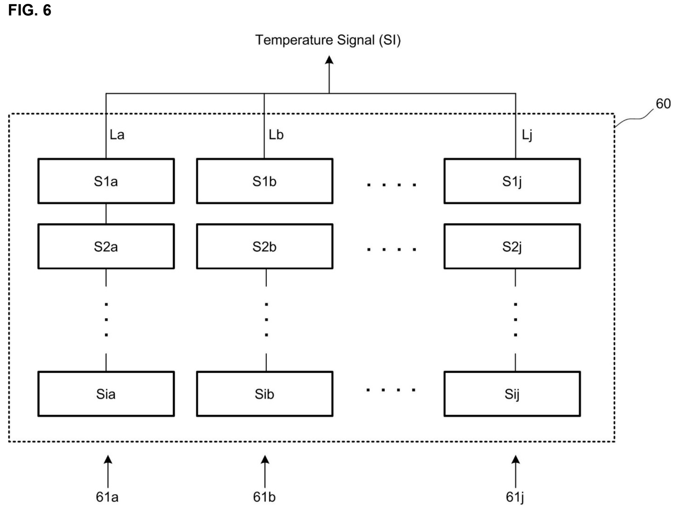

FIG. 6 is a schematic view of a temperature sensor array 60. Referring to FIG. 6, the temperature sensor array 60 may include a total of i × j temperature sensors, with i temperature sensors in the vertical direction and j temperature sensors in the horizontal direction. Temperature sensor columns 61a, 61b, ..., 61j may be connected via signal lines La, Lb, ..., Lj, respectively, which may provide an integrated temperature signal SI to a battery management apparatus 200.

The number of temperature sensors included in the temperature sensor array 60 may be determined in consideration of the size of each battery module 50, the number of battery cells 10 to be monitored for thermal runaway or overheating, and installation cost.

Referring to FIG. 5B, which illustrates a different embodiment from FIG. 5A, although there exist multiple temperature sensor columns 61a and 61b, only a single temperature sensor S1 may be arranged in a circuit section 56 of the battery module 50. This is because, unlike in a battery section 57 where a large number of battery cells 10 are widely distributed, in the circuit section 56, the points where heat is generated are relatively limited. However, since multiple temperature sensors S2a and S3a or S2b and S3b are still arranged in the battery section 57 for the temperature sensor column 61a or 61b, signal lines La and Lb that connect the temperature sensor columns 61a and 61b are commonly connected to the temperature sensor S1.

As illustrated above, the plurality of temperature sensors are vertically connected by a common signal line. However, this configuration is not limited thereto; the sensors may instead be connected horizontally by a common signal line. In the present invention, the term "temperature sensor column" encompasses both a structure in which multiple sensors are connected vertically and one in which they are connected horizontally.

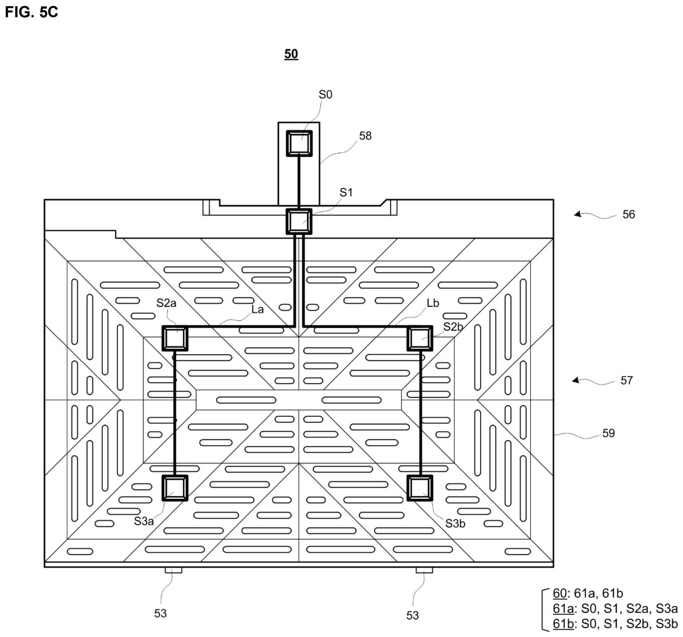

Meanwhile, referring to FIG. 5C, a post 58 extending upward from a module casing 59 is additionally provided in the battery module 50. If a temperature sensor S0 is arranged on the post 58, leakage of the insulating oil 20 can be detected at an earlier stage. That is, when the leakage of the insulating oil 20 is detected only by the temperature sensor S1 installed in a circuit section 56 of the module casing 59, the insulating oil 20 may already be nearing depletion. Therefore, by means of the temperature sensor S0, the leakage of the insulating oil 20 can be detected in advance.

In the aforementioned embodiments, the immersion-type energy storage device 100, where the battery modules 50, each housing a plurality of battery cells 10, are immersed in the insulating oil 20 within the housing 30 has been described so far, but the present disclosure is not limited thereto. That is, alternatively, a configuration in which the battery cells 10 are directly immersed in the insulating oil 20 within the housing 30 may also be possible.

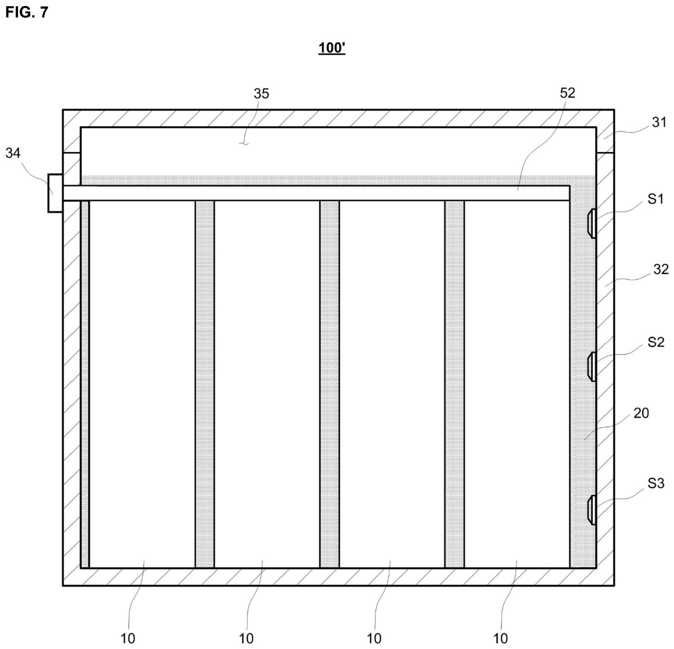

Referring to FIG. 7, a plurality of battery cells 10 are immersed in the insulating oil 20 filled in an accommodation space 35 of an immersion-type energy storage device 100'. However, since there is no separate module casing 59, a plurality of temperature sensors S1, S2, and S3, which are spaced apart in the vertical direction of the accommodation space 35, may be installed, for example, on an inner wall of a housing body 32.

Even in the embodiment of FIG. 7, since the temperature sensors S1, S2, and S3 are spaced apart in the vertical direction of the accommodation space 35, it is possible to determine whether a defect has occurred in insulating oil based on whether the pattern of temperature signals detected by the temperature sensors S1, S2, and S3 has changed over time.

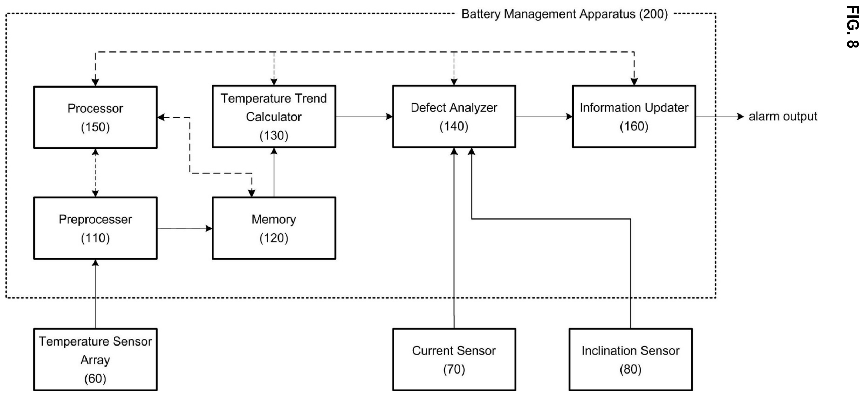

FIG. 8 is a block diagram illustrating the configuration of a battery management apparatus 200 according to an embodiment of the present disclosure.

As described above, the battery management apparatus 200 is housed within a housing 30 and mounted in a BMS casing 40 separate from each battery module 50. The battery management apparatus 200 is configured to receive information from each battery module 50 and to control the operation of battery cells 10 within each battery module 50.

To this end, the battery management apparatus 200 may include at least a processor 150 and a memory 120 that stores instructions executable by the processor 150. Each functional block within the battery management apparatus 200 is operated by the processor 150 executing the instructions.

The battery management apparatus 200 receives a temperature signal SI detected by a plurality of temperature sensors in a temperature sensor array 60 that are installed at different locations of each battery module 50, and determines whether a defect has occurred in insulating oil 20 based on whether the pattern of the temperature signal SI has changed over time. The defect in the insulating oil 20 may include leakage and/or degradation of the insulating oil 20. Specifically, referring to FIG. 8, the battery management apparatus 200 may include a preprocessor 110, a temperature trend calculator 130, a defect analyzer 140, and an information updater 160.

The preprocessor 110 receives temperature signals from the plurality of temperature sensors and calculates a representative value of the received temperature signals. For this, a digital low-pass filter may be used. The representative value of the received temperature signals is stored in the memory as needed. In addition, the preprocessor 110 may also perform exception handling in the event of an error caused by a fault in the immersion-type energy storage device 100.

Here, a representative value of temperature signals (e.g., a representative value of multiple sampled temperature signals), instead of the instantaneous values of the temperature signals, is used to suppress noise components included in the temperature signals measured by the plurality of temperature sensors.

The temperature trend calculator 130 determines the trend of the current temperature relative to a previous time point, considering the steady-state arrival time corresponding to a time constant, which is a design parameter of the digital filter. Here, the determined trend may include a temperature rise, fall, or maintenance.

The defect analyzer 140 checks the charging or discharging status of the battery cells 10 and identifies the index of each battery module 50.

For this, the defect analyzer 140 may receive the temperature signal SI from the temperature sensor array 60, which includes temperature sensors installed at different locations of each battery module 50, and may also receive a current signal detected by a current sensor 70.

The defect analyzer 140 first determines whether the battery cells 10 are in a charging or discharging state based on the current signal provided by the current sensor 70. When the battery cells 10 are in an idle state instead of the charging or discharging state, no temperature change occurs in the insulating oil 20, and thus, defect diagnosis cannot be performed.

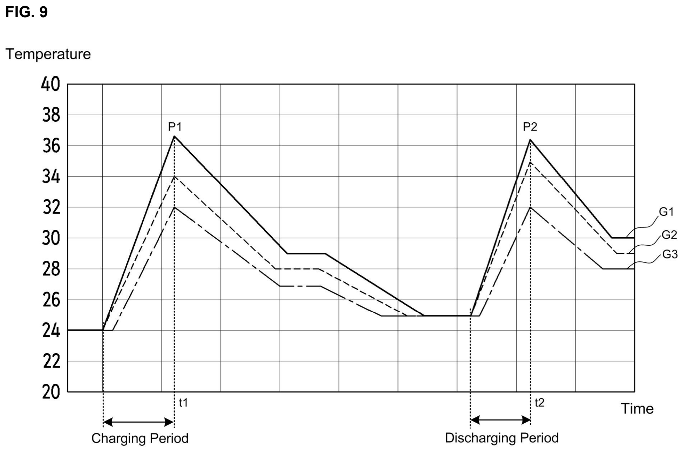

When the battery cells 10 are in the charging or discharging state, the defect analyzer 140 determines whether a defect has occurred in the insulating oil 20 based on whether the pattern of the temperature signal SI has changed over time. Even if the pattern of the temperature signal SI has changed, the change may be temporary or due to signal noise. Therefore, the defect analyzer 140 may determine that a defect has occurred in the insulating oil 20 only when the change in the pattern of the temperature signal SI continues for more than a predetermined period of time. The pattern of the temperature signal SI will be described later in further detail with reference to FIGS. 9 through 11.

The defect analyzer 140 may additionally receive an inclination signal detected by an inclination sensor 80. This inclination signal indicates that the immersion-type energy storage device 100, mounted on a mobile platform such as a vehicle, ship, submarine, or aircraft, is positioned in a tilted orientation relative to the direction of gravity. When the immersion-type energy storage device 100 is tilted, even in the absence of leakage of the insulating oil 20, the upper portions of some battery modules 50 may become exposed to the air layer in the upper part of the housing 30, leading to a false alarm. Preferably, the defect analyzer 140 may determine whether a defect exists in the insulating oil 20 only when the immersion-type energy storage device 100 is positioned at an inclination angle less than a threshold.

Meanwhile, as illustrated in FIG. 6, since the temperature sensor array 60 includes a plurality of temperature sensor columns 61a, 61b, and 61j, it is necessary to establish a criterion for determining a change in the pattern of temperature signals because the temperature sensor columns 61a, 61b, and 61j may not always provide the same result.

This criterion is associated with the sensitivity of detecting a defect in the insulating oil 20. To detect a defect in the insulating oil 20 with high sensitivity, the defect analyzer 140 may determine that the insulating oil 20 is defective if a change in the temperature signal pattern is detected in at least one of the temperature sensor columns 61a, 61b, and 61j.

Conversely, to detect a defect in the insulating oil 20 with low sensitivity, the defect analyzer 140 may determine that the insulating oil 20 is defective only when a change in the temperature signal pattern is detected in all of the temperature sensor columns 61a, 61b, and 61j.

Alternatively, the defect analyzer 140 may obtain a representative value (e.g., an average value) of temperature signals measured by temperature sensors S1a, S1b, and S1j, S2a, S2b, and S2j, or Sia, Sib, and Sij located in the same vertical sensor row, and may determine whether the pattern of the representative temperature signal has changed based on the representative value.

Finally, when the defect analyzer 140 determines that a defect has occurred in the insulating oil 20, the information updater 160 may update and record defect information in the memory 120, and simultaneously generate an alarm for external notification.

FIG. 9 is a graph illustrating the temporal changes in the temperature of normal insulating oil 20 when the immersion-type energy storage device 100 is in the charging or discharging state, as detected by each of a plurality of upper, middle, and lower temperature sensors S1, S2, and S3, which are spaced apart in the vertical direction within an individual temperature sensor column. Referring to FIG. 9, the horizontal axis represents time, and the vertical axis represents temperature (°C).

As described above, with respect to the vertical direction, the upper temperature sensor S1 is located at the top of each battery module 50, the middle temperature sensor S2 is located at the middle of each battery module 50, and the lower temperature sensor S3 is located at the bottom of each battery module 50.

In general, as the temperature rises, the density of the insulating oil 20 decreases, causing it to rise to the upper part of the accommodation space 35, and as the temperature drops, the density of the insulating oil 20 increases, causing it to descend to the lower part of the accommodation space 35. Accordingly, a temperature signal G1 measured by the upper temperature sensor S1 has the greatest value, while a temperature signal G3 measured by the lower temperature sensor S3 has the smallest value.

That is, as the battery cells 10 undergoes charging and discharging, the temperature signals G1, G2, and G3 exhibit changes such as rising, remaining constant, or falling over time, but the relationship between the temperature signals G1, G2, and G3 remains consistent as "G1 > G2 > G3." Also, it can be seen that peak times t1 and t2, at which peak values P1 and P2 appear in the temperature signals G1, G2, and G3, are all the same.

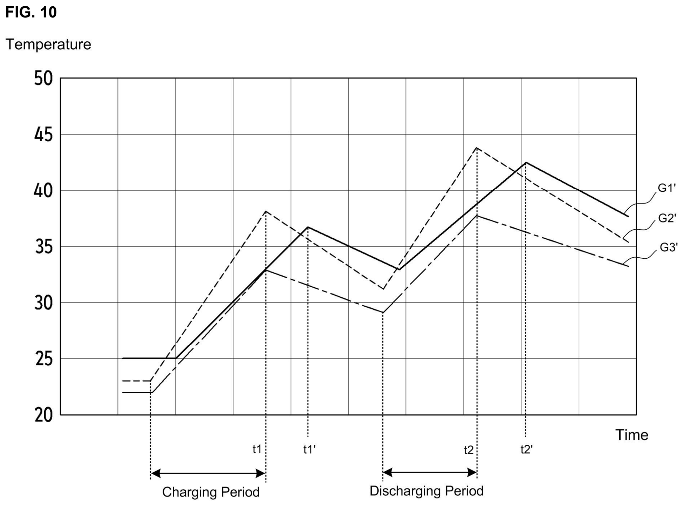

FIG. 10 is a graph illustrating temporal temperature changes of the insulating oil 20 in which leakage has occurred, as detected by each of the upper, middle, and lower temperature sensors S1, S2, and S3 that are vertically spaced apart in the individual temperature sensor column.

Referring to FIG. 10, due to leakage of the insulating oil 20, the upper temperature sensor S1 is exposed to the air layer inside the housing 30, whereas the middle and lower temperature sensors S2 and S3 remain immersed in the insulating oil 20. Compared to FIG. 9, several significant changes occur in FIG. 10.

First, unlike in FIG. 9 where G1 > G2 > G3, the upper temperature sensor S1 in FIG. 10 cannot indicate as high a temperature as when immersed in the insulating oil 20, because it is exposed to the air layer. This means that battery cells 10 located at the top of each battery module 50 may become overheated due to inadequate cooling (or heat exchange).

Accordingly, as time passes, a "magnitude reversal pattern" appears in which a temperature signal G1' detected by the upper temperature sensor S1 is lower than temperature signals G2' and G3' detected by the middle and lower temperature sensors S2 and S3, respectively. This magnitude reversal pattern is especially noticeable during charging and discharging periods. When the condition for the occurrence of the magnitude reversal pattern is satisfied, the defect analyzer 140 may determine that leakage of the insulating oil 20 has occurred.

In addition to or independently of the occurrence of the magnitude reversal pattern, the defect analyzer 140 may determine that leakage of the insulating oil 20 has occurred if the condition for the occurrence of a "gradient reversal pattern" is satisfied.

The gradient reversal pattern refers to a case where the gradient (or time derivative) of the temperature signal G1' detected by the upper temperature sensor S1 is smaller than the gradients of the temperature signals G2' and G3' detected by the middle and lower temperature sensors S2 and S3.

In FIG. 9, during the charging or discharging periods, the magnitude of the gradients is in the order of the temperature signal G1' from the upper temperature sensor S1, the temperature signal G2' from the middle temperature sensor S2, and the temperature signal G3' from the lower temperature sensor S3. However, in FIG. 10, the order of the gradient magnitudes is reversed to that of the temperature signal G2' from the middle temperature sensor S2, the temperature signal G3' from the lower temperature sensor S3, and the temperature signal G1' from the upper temperature sensor S1. When the condition for the occurrence of the gradient reversal pattern is satisfied, the defect analyzer 140 may determine that leakage of the insulating oil 20 has occurred.

This gradient reversal pattern can be detected even before the occurrence of the magnitude reversal pattern, which allows the defect analyzer 140 to detect leakage of the insulating oil 20 more promptly. However, for more reliable detection of leakage, the condition may require that both the magnitude reversal pattern and the gradient reversal pattern occur simultaneously.

Meanwhile, since the upper temperature sensor S1, which is exposed to the air layer inside the housing 30, cannot promptly reflect the temperature changes of the battery cells 10 caused by charging and discharging, as compared to the middle and lower temperature sensors S2 and S3 that remain immersed in the insulating oil 20, a "peak shift" occurs, where peaks of the temperature signal G1' are delayed.

Referring to FIG. 10, during the charging and discharging periods, peaks of each of the temperature signals G2' and G3' detected by the middle and lower temperature sensors S2 and S3 occur at times t1 and t2, whereas the peaks of the temperature signal G1' detected by the upper temperature sensor S1 occur at later times t1' and t2' than t1 and t2, respectively.

Accordingly, when, during or after the charging period, the peak position t1' of the temperature signal G1' detected by the upper temperature sensor S1 differs from the peak position t1 of the temperature signals G2' and G3' detected by the middle and lower temperature sensors S2 and S3 in the direction of the time axis, the defect analyzer 140 may determine the condition for the occurrence of a "peak shift pattern" is met. Then, the defect analyzer 140 may determine that leakage has occurred in the insulating oil 20. The same applies to the discharging period and its aftermath.

This peak shift pattern may be determined as follows. First, if the sign (positive or negative) of the difference between a current temperature signal detected by the upper temperature sensor S1 and a previous temperature signal detected one minute earlier by the upper temperature sensor S1 differs from the sign of the corresponding difference for the middle or lower sensors S2 and S3, then the magnitude reversal pattern may be determined to have occurred. For example, in the period from t1 to t1' in FIG. 10, the sign of this difference for the upper temperature sensor S1 is negative, while the sign of this difference for the middle or lower sensors S2 and S3 is positive. The same applies to the period from t2 to t2' in FIG. 10.

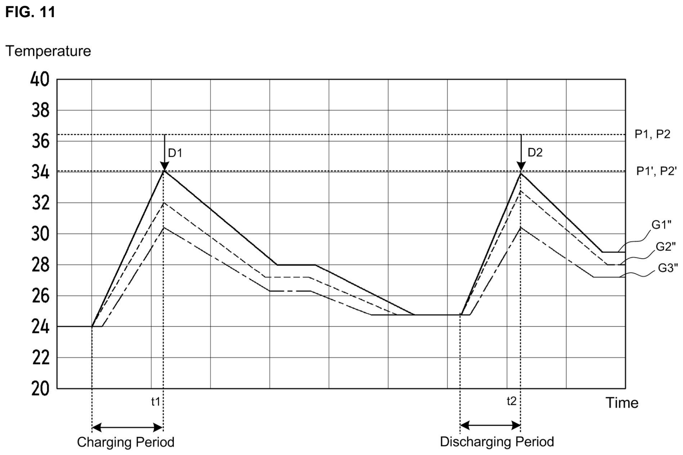

FIG. 11 is a graph illustrating temporal temperature changes of degraded insulating oil 20 as detected by each of the upper, middle, and lower temperature sensors S1, S2, and S3 that are vertically spaced apart in the individual temperature sensor column.

When the insulating oil 20 has been used for long such that its composition or viscosity changes or foreign substances are introduced, the performance of the insulating oil 20 itself may deteriorate, and it may become unable to properly absorb the heat generated by the battery cells 10. Unlike in the case of leakage, this deterioration results in an overall decrease in temperature signals G1", G2", and G3" measured by all the upper, middle, and lower temperature sensors S1, S2, and S3 at their respective vertical positions.

Referring to FIG. 11, although the trends of the temperature signals G1", G2", and G3" remain unchanged compared to FIG. 10, the levels of the temperature signals G1", G2", and G3" are generally lower. Since such level reduction is more evident at the peaks of the temperature signals G1", G2", and G3", the defect analyzer 140 may determine that degradation of the insulating oil 20 has occurred if the peak height of the temperature signal detected by at least one of the sensors S1, S2, and S3 falls below a predetermined threshold level. Particularly, if a peak height P' of the temperature signal G1" detected by the uppermost sensor S1, which has the highest sensitivity, is lower than the peak values P1 and P2 of FIG. 9 by more than a threshold amount D1 or D2, the defect analyzer 140 may determine that degradation of the insulating oil 20 has occurred.

Alternatively, for more robust verification, the defect analyzer 140 may determine that degradation of the insulating oil 20 has occurred if the average of the temperature signals G1", G2", and G3" from the upper, middle, and lower temperature sensors S1, S2, and S3 drops below a threshold level.

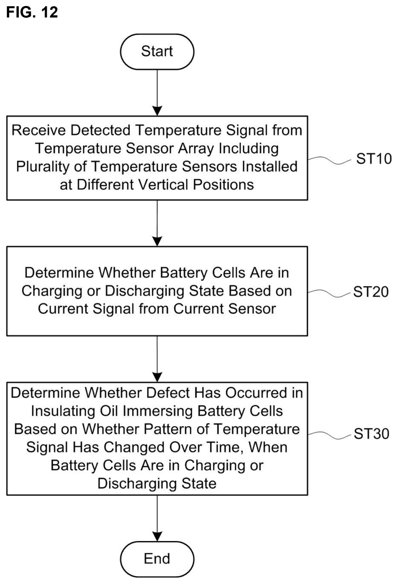

FIG. 12 is a flowchart illustrating a battery management method according to an embodiment of the present disclosure.

Referring to FIG. 12, first, the preprocessor 110 receives, from a temperature sensor array 60 including a plurality of temperature sensors S1, S2, and S3 that are installed at different vertical positions, a temperature signal SI detected by the temperature sensors S1, S2, and S3 (ST10).

The defect analyzer 140 determines whether battery cells 10 are in the charging or discharging state based on a current signal provided by the current sensor 70 (ST20).

When the battery cells 10 are in the charging or discharging state, the defect analyzer 140 determines whether a defect has occurred in the insulating oil 20 that immerses the battery cells 10, based on whether the pattern of the temperature signals G1, G2, and G3 detected by the temperature sensors S1, S2, and S3 has changed over time (ST30).

Specifically, if a magnitude reversal pattern occurs over time in which the temperature signal detected by the temperature sensor S1 at a first position is lower than the temperature signal detected by the temperature sensor S2 or S3 at a second position, which is lower than the first position, the defect analyzer 140 may determine that leakage of the insulating oil 20 has occurred.

In another embodiment, if a gradient reversal pattern occurs over time in which the time gradient of the temperature signal detected by the temperature sensor S1 is smaller than the time gradient of the temperature signal detected by the temperature sensor S2 or S3, the defect analyzer 140 may determine that leakage of the insulating oil 20 has occurred.

In yet another embodiment, if a peak shift pattern occurs over time in which the peak position of the temperature signal detected by the temperature sensor S1 differs in time from the peak position of the temperature signal detected by the temperature sensor S2 or S3, the defect analyzer 140 may determine that leakage of the insulating oil 20 has occurred.

In still another embodiment, if the peak height of the temperature signal detected by at least one of the temperature sensors S1, S2, and S3 is lower than a reference level by more than a threshold amount, the defect analyzer 140 may determine that degradation of the insulating oil 20 has occurred.

Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the appended claims.

## Claims

1. An immersion-type energy storage device (100, 100') comprising:
a housing (30) having an accommodation space (35) therein;
one or more battery cells (10) accommodated in the accommodation space (35) of the housing (30);
insulating oil (20) that fills the accommodation space (35) to immerse the battery cells (10) and cool the battery cells (10);
a temperature sensor array (60) including a plurality of temperature sensors installed at different locations that are vertically spaced apart in the accommodation space (35) to detect temperature; and
a battery management apparatus (200) configured to determine whether a defect has occurred in the insulating oil (20) based on whether a pattern of a temperature signal (G1, G2, G3) detected by the plurality of temperature sensors has changed over time.

2. The immersion-type energy storage device (100, 100') of claim 1, wherein
the battery cells (10) are mounted in a module casing (59) of a battery module (50) and immersed in the insulating oil (20), and
the plurality of temperature sensors are installed on the module casing (59).

3. The immersion-type energy storage device (100, 100') of claim 1 or 2, wherein the defect in the insulating oil (20) includes leakage and/or degradation of the insulating oil (20).

4. The immersion-type energy storage device (100, 100') of claims 1 to 3, wherein the temperature signal (G1, G2, G3) is defined as a representative value of multiple sampled values.

5. The immersion-type energy storage device (100, 100') of claims 1 to 4, wherein the battery management apparatus (200) determines that the defect in the insulating oil (20) has occurred only when the pattern of the temperature signal (G1, G2, G3) has changed and has continued for more than a predetermined period of time.

6. The immersion-type energy storage device (100, 100') of claims 1 to 5, wherein the battery management apparatus (200) determines whether a defect has occurred in the insulating oil (20) when the battery cells (10) are in a charging state or a discharging state, based on a signal from a current sensor (70).

7. The immersion-type energy storage device (100, 100') of claims 1 to 6, wherein the plurality of temperature sensors form an individual temperature sensor column (61a, 61b, ..., 61j) connected by a common signal line.

8. The immersion-type energy storage device (100, 100') of claims 1 to 7, wherein the temperature sensor array (60) includes a plurality of individual temperature sensor columns (61a, 61b, ..., 61j) which are installed at different locations in a horizontal direction of the module casing (59).

9. The immersion-type energy storage device (100, 100') of claim 8, wherein the battery management apparatus (200) determines that a defect has occurred in the insulating oil (20) when a change in the pattern of the temperature signal (G1, G2, G3) is detected in at least one of the plurality of individual temperature sensor columns (61a, 61b, ..., 61j).

10. The immersion-type energy storage device (100, 100') of claim 8 or 9, wherein one or more temperature sensors positioned at a highest position in the plurality of individual temperature sensor columns (61a, 61b,..., 61j) are located in a circuit section (56) of the module casing (59) and /or wherein a single temperature sensor is located in the circuit section (56), and is commonly connected to signal lines of the plurality of individual temperature sensor columns (61a, 61b,..., 61j).

11. The immersion-type energy storage device (100, 100') of claims 1 to 10, wherein an air layer in an upper portion of the accommodation space (35) is formed rather than completely filling the accommodation space (35) with the insulating oil (20), thus utilizing the air layer as a buffer in the event of boiling or splashing of the insulating oil (20) due to thermal runaway, thereby suppressing damage to the housing (30), and also helping the insulating oil (20) to flow and circulate smoothly within the accommodation space (35).

12. The immersion-type energy storage device (100, 100') of claims 1 to 11, wherein the battery management apparatus (200) determines that leakage of the insulating oil (20) has occurred when a gradient reversal pattern has occurred in which a time gradient of a temperature signal (G1, G2, G3) detected by a first temperature sensor located at a first position is smaller than a time gradient of a temperature signal (G1, G2, G3) detected by a second temperature sensor located at a second position below the first position.

13. The immersion-type energy storage device (100, 100') of claims 1 to 12, wherein the battery management apparatus (200) determines that leakage of the insulating oil (20) has occurred when a peak shift pattern has occurred in which a peak position of a temperature signal (G1, G2, G3) detected by a first temperature sensor located at a first position differs in time from a peak position of a temperature signal (G1, G2, G3) detected by a second temperature sensor located at a second position below the first position.

14. The immersion-type energy storage device (100, 100') of claims 1 to 13, wherein the battery management apparatus (200) determines that the peak shift pattern has occurred when a sign of a difference between a temperature signal (G1, G2, G3) detected by the first temperature sensor at a previous time and a temperature signal (G1, G2, G3) detected by the first temperature sensor at a current time differs from a sign of a difference between a temperature signal (G1, G2, G3) detected by the second temperature sensor at the previous time and a temperature signal (G1, G2, G3) detected by the second temperature sensor at the current time.

15. A battery management method performed in a device including a processor (150) and a memory (120) that stores program instructions executed by the processor (150), the method comprising:
receiving, from a temperature sensor array (60) including a plurality of temperature sensors installed at different vertical positions, a temperature signal (G1, G2, G3) detected by the plurality of temperature sensors;
determining, based on a current signal provided by a current sensor (70), whether battery cells (10) are in a charging state or a discharging state; and
when the battery cells (10) are in the charging state or the discharging state, determining whether a defect has occurred in insulating oil (20) that immerses the battery cells (10) based on whether a pattern of the temperature signal (G1, G2, G3) detected by the plurality of temperature sensors has changed over time.
